# EUROPÄISCHE PATENTSCHRIFT

(11) **EP 1 651 439 B1**
(45) Veröffentlichungstag und Bekanntmachung des Hinweises auf die Patenterteilung: **09.04.2008**
(21) Anmeldenummer: 04738784.0
(22) Anmeldetag: 25.06.2004
(51) Int. Cl.: B32B 39/00, B32B 37/26, B32B 37/10

(54) **VORRICHTUNG ZUM SCHRITTWEISEN LAMINIEREN VON MULTILAYERN**
DEVICE FOR STEP-WISE LAMINATION OF STEPS
DISPOSITIF DE LAMINAGE DE MULTICOUCHES PAR ETAPES

(30) Priorität: 05.08.2003 DE 10335693
(43) Veröffentlichungstag der Anmeldung: 03.05.2006
(73) Patentinhaber: Maschinenfabrik Lauffer GmbH & Co. KG, 72160 Horb (DE)
(72) Erfinder: MAI, Josef, 72160 Horb-Rexingen (DE)
(74) Vertreter: Späth, Dieter
(86) Internationale Anmeldenummer: PCT/DE2004/001335
(87) Internationale Veröffentlichungsnummer: WO 2005/014284

(56) Entgegenhaltungen:
- DE-A- 3 413 053
- DE-U- 20 017 405
- US-A- 5 470 428
- HELD H-J ET AL: "SPES - STUFENPRESSEN-EXPERTENSYSTEM" VDI Z, VDI VERLAG GMBH. DUSSELDORF, DE, Bd. 132, Nr. 2, 1. Februar 1990 (1990-02-01), Seiten 34-36,39, XP000096307 ISSN: 0042-1766

## Beschreibung

Die Erfindung betrifft eine Vorrichtung zum schrittweisen Laminieren von Multilayern mit den Merkmalen des Oberbegriffs des Anspruchs 1, wie sie beispielsweise aus DE-A1-34 13 053 bekannt ist.

Derartige Vorrichtungen werden auch als Stufenpressen bezeichnet, weil ein Laminiergut schrittweise durch aufeinanderfolgend angeordnete Presseinrichtungen (Pressenstufen) gefördert wird, die jeweils eine ganzzahlige Anzahl der späteren Multilayer aufnehmen und pressen. Die Presseinrichtungen weisen Heiz- und/oder Kühleinrichtungen auf und sind einzeln oder in Gruppen temperierbar. In jeder Presseinrichtung wird das die Multilayer bildende Laminiergut gepresst und auf eine vorgegebene Temperatur erwärmt oder gekühlt und ggf. eine vorgegebene Zeitspanne auf der Temperatur gehalten, bevor alle Presseinrichtungen gemeinsam geöffnet und das Laminiergut einen Schritt, d.h. um eine Presseinrichtung, weiter gefördert wird. Zum Fördern sind zwei Förderbänder auf einer Unter- und einer Oberseite des Laminierguts vorgesehen, deren fördernde Trume alle Presseinrichtungen durchlaufen und die an beiden Enden der Presseinrichtungen um Umlenkrollen umlaufen.

Multilayer weisen üblicherweise eine Innenlage auf, auf die vorzugsweise beidseitig eine Außenlage laminiert wird. Die Innenlage lässt sich allgemein auch als Träger bezeichnen. Die Außenlage weist bei Multilayern eine Metallfolie, üblicherweise aus Kupfer oder Aluminium auf, aus der nach dem Laminieren durch Ätzen Leiterbahnen hergestellt werden. Zum Laminieren (Verkleben von Außen- und Innenlage) kommmt zwischen die Außenlage und die Innenlage eine oder mehrere Zwischenlagen aus einem elektrisch isolierenden, durch Wärme und Druck schmelzbaren Kunststoff aufweisen. Bei Multilayern werden die Zwischenlagen üblicherweise als Prepreg bezeichnet. Sie können als einzelne Bögen, als separates Band oder im Verbund als an der Metallfolie haftendes Band zugeführt werden. In letzterem Fall wird auch von einer Verbundfolie gesprochen. Um auf beide Seiten der Innenlage mehrere Metallschichten laminieren zu können, kann der Laminiervorgang wiederholt werden, wobei die außenliegenden Metallschichten nach jedem Laminieren zu Leiterbahnen geätzt werden müssen bevor eine weitere Zwischen- und Außenlage laminiert wird. Nach dem Laminieren wird das Laminiergut in Platten getrennt, die eine ganzzahlige Anzahl der späteren Multilayer umfassen. Diese Laminatplatten können bei weiteren Laminierdurchläufen als Innenlagen aufgefasst werden.

Die Innenlagen werden einzeln in Plattenform oder beim ersten Laminierdurchgang auch als Bänder zugeführt. Die Außenlagen und Zwischenlagen werden üblicherweise als Bänder zugeführt, grundsätzlich ist auch ein Auflegen einzelner Bögen denkbar.

Außer Multilayern lassen sich mit der erfindungsgemäßen Vorrichtung auch andere Laminate, d.h. Schichtverbundplatten beispielsweise für Kredit- oder Scheckkarten herstellen. Das Laminieren erfolgt üblicherweise in einem evakuierten Raum, in dem die Presseinrichtungen angeordnet sind. Durch Druck- und Temperatureinwirkung in den Presseinrichtungen schmelzen die Innenlage und, sofern vorhanden, die Zwischenlagen auf und verbinden die Lagen des Laminierguts nach dem Abkühlen in der oder den letzten Presseinrichtungen stoffschlüssig miteinander.

Der Erfindung liegt die Aufgabe zugrunde, eine Vorrichtung zum schrittweisen Laminieren von Multilayern oder allgemein Schichtverbundwerkstoffen vorzuschlagen, die keine umlaufenden Förderbänder zum Fördern des Laminierguts durch die Presseinrichtungen benötigt.

Diese Aufgabe wird erfindungsgemäß durch die Merkmale des Anspruchs 1 gelöst. Die erfindungsgemäße Vorrichtung weist mindestens eine in Förderrichtung letzte Presseinrichtung auf, die in und entgegen einer Förderrichtung bewegbar ist. Es können mehrere letzte Presseinrichtungen gemeinsam bewegbar sein. Zum Fördern des Laminierguts durch die Presseinrichtungen werden mit Ausnahme der beweglichen letzten Presseinrichtungen alle Presseinrichtungen geöffnet und die geschlossenen, beweglichen Presseinrichtungen werden um die Länge einer Presseinrichtung oder mehrerer Presseinrichtungen, also um einen Schritt, in Förderrichtung bewegt. Dadurch wird das bandförmige Laminiergut um einen Schritt durch die Vorrichtung gefördert. Die geöffneten, nicht bewegten Presseinrichtungen werden anschließend geschlossen und die bewegbaren Presseinrichtungen geöffnet und zurück in ihre Ausgangsposition bewegt, bevor sie wieder geschlossen werden. Das schrittweise Fördern des Laminierguts durch die Presseinrichtungen erfolgt erfindungsgemäß also durch Bewegen der letzten Presseinrichtungen in Förderrichtung. Erforderlich dafür ist, dass mindestens die unterste Lage des Multilayers bzw. Laminierguts ein durchgehendes Band ist, das alle Presseinrichtungen durchsetzt. Vorzugsweise ist auch die oberste Lage des Laminierguts ein durchgehendes Band, um ein Haften an oberen Stempeln der Presseinrichtungen beim Öffnen der Presseinrichtungen zu vermeiden. Alle anderen Lagen des Laminierguts können durchgehende Bänder und/oder Platten oder Bögen sein, die auf dem untersten Band liegen und mit diesem schrittweise durch die Presseinrichtungen gefördert werden.

Die Erfindung hat zunächst den Vorteil, dass sie ohne separate Förderbänder auskommt, die zusätzlich noch jeweils zwei Umlenkrollen und üblicherweise Spanneinrichtungen benötigen. Weiterer Vorteil ist, dass die Presseinrichtungen das Laminiergut unmittelbar, d.h. ohne zwischenliegendes Förderband, heizen oder kühlen, die Wärmeübertragung ist dadurch verbessert.

Eine bevorzugte Ausgestaltung der Erfindung weist eine Abführeinrichtung auf, die in Förderrichtung nach der letzten Presseinrichtung angeordnet ist und die mindestens eine äußerste Lage nach dem Laminieren vom Laminiergut entfernt. Die äußerste Lage kann eine Lage einer mehrere Lagen (Schichten) aufweisenden Außenlage sein. Als Außenlage wird in diesem Fall also eine Verbundfolie mit beispielsweise einer Metallfolie und einer oder mehreren Kunststofffolien zugeführt, von denen nach dem Laminieren die äußerste (Kunststoff-) Lage wieder entfernt wird. Es können auch mehrere Außenlagen bzw. Außen- und Zwischenlagen zugeführt werden, von denen die äußerste Lage nach dem Laminieren wieder entfernt wird. Die zu entfernende Lage weist vorzugsweise einen höheren Schmelzpunkt auf, d.h. sie wird beim Heizen und Pressen nicht angeschmolzen sondern haftet auch nach dem Laminieren nur ohne Stoffschluss am Laminiergut. Die äußerste Lage kann deswegen auch aus Metall bestehen (Aluminiumfolie). Vorzugsweise werden äußerste Lagen auf der Ober- und der Unterseite des Laminierguts vom Laminiergut entfernt.

Die Zu- und Abführeinrichtungen weisen beispielsweise Wickeleinrichtungen auf, von der die Außenlagen ab- und aufgewickelt werden. Die Abführeinrichtung weist zusätzlich einen Drehantrieb zum Aufwickeln der äußersten Lage auf. Die äußerste Lage, die erfindungsgemäß nach dem Laminieren vom Laminiergut entfernt wird, hat den Vorteil, dass eine Verschmutzung des Laminierguts vermieden wird. Die äußerste Lage wird neu und damit unverschmutzt den Presseinrichtungen zugeführt und nach dem Laminieren entfernt. Eine Reinigung, wie sie bei umlaufenden Förderbändern unbedingt erforderlich ist, entfällt. Es wird vermieden, dass Schmutzpartikel in die Presseinrichtungen eingetragen werden, was bei umlaufenden Förderbändern passieren kann. Dies ist deshalb ein großer Vorteil, weil bereits kleinste Schmutzpartikel Multilayer oder auch sonstige Laminate wie Kredit- und Scheckkarten unbrauchbar machen. Durch Entfall einer ansonsten erforderlichen Reinigungseinrichtung für umlaufende Förderbänder ermöglicht das erfindungsgemäße Entfernen der äußersten Lage vom Laminiergut nach dem Laminieren eine preisgünstigere Laminiervorrichtung. Zudem ist die Gefahr von Ausschuss durch Schmutzeintrag verringert. Weiterer Vorteil ist, dass ein rücklaufendes Trum eines umlaufenden Förderbandes entfällt, so dass die Presseinrichtungen besser zugänglich und einfacher aufstellbar und ihrer Konstruktion einfacher zu gestalten sind.

Eine Ausgestaltung der Erfindung sieht eine Trenneinrichtung vor, die das Laminiergut nach dem Laminieren und nach Entfernen der äußersten Lagen in Platten oder Bögen trennt, die eine ganze Anzahl von Multilayern umfassen.

Die Erfindung wird nachfolgend anhand eines in der Zeichnung dargestellten Ausführungsbeispiels näher erläutert. Die Figuren zeigen eine erfindungsgemäße Vorrichtung zum schrittweisen Laminieren von Multilayern in einer schematisierten und vereinfachten Seitenansicht, wobei die Figuren aufeinanderfolgende Verfahrensschritte zeigen.

Die in der Zeichnung dargestellte, erfindungsgemäße Vorrichtung 10 dient zum schrittweisen Laminieren vom Multilayern 12. Die Vorrichtung 10 weist vier Presseinrichtungen 14, 16 auf, die in einer Förderrichtung aufeinanderfolgend angeordnet sind. Jeweils zwei der Presseinrichtungen 14, 16 arbeiten parallel, ein Laminiergut 18 wird in jedem Verfahrensschritt um die Länge zweier Presseinrichtungen 14, 16 weitergefördert.

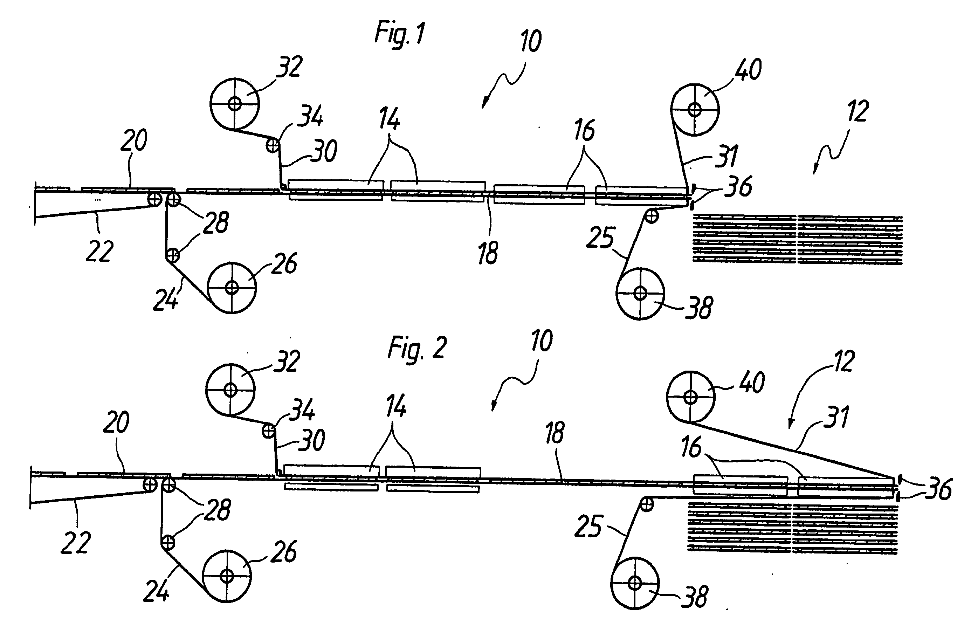

Die beiden in Förderrichtung ersten Presseinrichtungen 14 weisen Heizeinrichtungen auf, die beiden letzten Presseinrichtungen 16 weisen Kühleinrichtungen auf. Die beiden letzten Presseinrichtungen 16 sind gemeinsam um die Länge zweier Presseinrichtungen 14, 16, d.h. einen Verfahrensschritt in und entgegen der Förderrichtung bewegbar (vgl. Figuren 1 und 2). Das Vorsehen jeweils zweier parallel arbeitender Presseinrichtungen 14, 16 erhöht einen Durchsatz der Vorrichtung 10. Grundsätzlich können auch jeweils einzelne Presseinrichtungen vorgesehen sein und es kann das Laminiergut in aufeinanderfolgenden Presseinrichtungen stufenweise auf steigende Temperaturen erwärmt und wieder abgekühlt werden (nicht dargestellt).

Die Vorrichtung 10 mit den aufeinanderfolgenden Presseinrichtungen 14, 16 kann auch als Stufenpresse bezeichnet werden. In der Zeichnung ist die Förderrichtung von links nach rechts.

Als Laminiergut 18 werden plattenförmige Innenlagen 20 den Presseinrichtungen 14, 16 zugeführt. Die Innenlagen 20 bestehen üblicherweise aus einem klebfähigen Dielektrikum, beispielsweise aus einem harzimprägnierten Glasfasergewebe, dessen Harz unter Temperatur- und/oder Druckeinwirkung schmilzt und anschließend aushärtet. Die Innenlagen 20 sind elektrisch isolierend. Als Einrichtung zum Zuführen der Innenlagen 20 dient beispielsweise ein Bandförderer 22. Die Innenlagen 20 gelangen vor der ersten Presseinrichtung 14 auf ein unteres Außenlageband 24, welches von einer Vorratsrolle 26 abgewickelt und über Umlenkrollen 28 den Presseinrichtungen 14, 16 zugeführt wird. Die Vorratsrolle 26 und die Umlenkrollen 28 bilden eine Einrichtung zum Zuführen des unteren Außenlagebandes 24. Das Außenlageband 24 besteht aus einer Metall-/Kunststoff-Verbundfolie, sie weist eine Metallfolie beispielsweise aus Kupfer auf, die an einer Kunststofffolie 25 aus beispielsweise Polyester haftet. Die Kunststofffolie 25 des Außenlagebandes 24 weist einen höheren Schmelzpunkt als die Innenlagen 20 auf. Das Außenlageband 24 wird so zugeführt, dass die Metallfolie sich oben befindet, d.h. die Innenlagen 20 liegen auf der Metallfolie des Außenlagebandes 24 auf.

Ein oberes Außenlageband 30 wird von einer Vorratsrolle 32 abgewickelt und über Umlenkrollen 34 auf eine Oberseite der Innenlagen 20 aufliegend den Presseinrichtungen 14, 16 zugeführt. Die Vorratsrolle 32 und die Umlenkrollen 34 bilden eine Einrichtung zum Zuführen des oberen Außenlagebandes 30. Das obere Außenlageband 30 ist ebenso wie das untere Außenlageband 24 eine Verbundfolie und weist eine Metallfolie beispielsweise aus Kupfer auf, die an einer Kunststofffolie 31, beispielsweise aus Polyester haftet. Das obere Außenlageband 30 wird so zugeführt, dass die Metallfolie sich unten befindet und auf den Innenlagen 20 zu liegen kommt.

In einem ersten, in Figur 1 dargestellten Verfahrensschritt sind alle vier Presseinrichtungen 14, 16 geschlossen, in den ersten beiden Presseinrichtungen 14 wird das Laminiergut 18 unter Druck bis zum Schmelzen der Innenlagen 20 erwärmt. In den beiden letzten Presseinrichtungen 16 wird das Laminiergut 18 gekühlt, so dass das Harz der Innenlagen 10 aushärtet und sich stoffschlüssig mit den Metallfolien der Außenlagebänder 24, 30 verbindet. Die Kunststofffolien 25, 31 der Außenlagebänder 24, 30, die einen höheren Schmelzpunkt als die Innenlagen 20 aufweisen, werden nicht angeschmolzen.

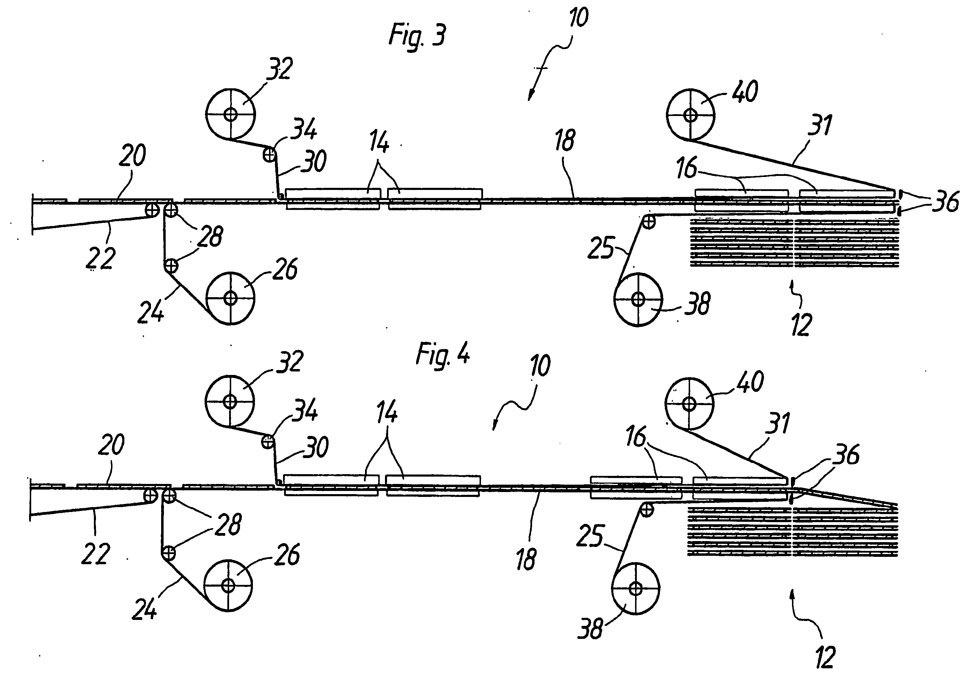

In einem zweiten, in Figur 2 dargestellten Verfahrensschritt werden die beiden ersten Presseinrichtungen 14 geöffnet und die bewegbaren beiden letzten Presseinrichtungen 16 werden um die Länge zweier Presseinrichtungen 14, 16, d.h. einen Schritt in Förderrichtung bewegt. Dadurch wird das Laminiergut 18 um die Länge zweier Presseinrichtungen 14, 16 durch die Vorrichtung 10 gefördert. In einem dritten, in Figur 3 dargestellten Verfahrensschritt werden die beiden ersten Presseinrichtungen 14 wieder geschlossen und erwärmen das Laminiergut 18. Die beiden letzten Presseinrichtungen 16 werden geöffnet (Figur 3) und in zwei Schritten um jeweils die Länge einer Presseinrichtung 14, 16 entgegen der Förderrichtung zurück zu den beiden ersten Presseinrichtungen 14 bewegt. Die geschlossenen Presseinrichtungen 14 halten das Laminiergut 18, so dass es nicht von den entgegen der Förderrichtung zurückbewegten letzten Presseinrichtungen 16 zurückgeschoben wird.

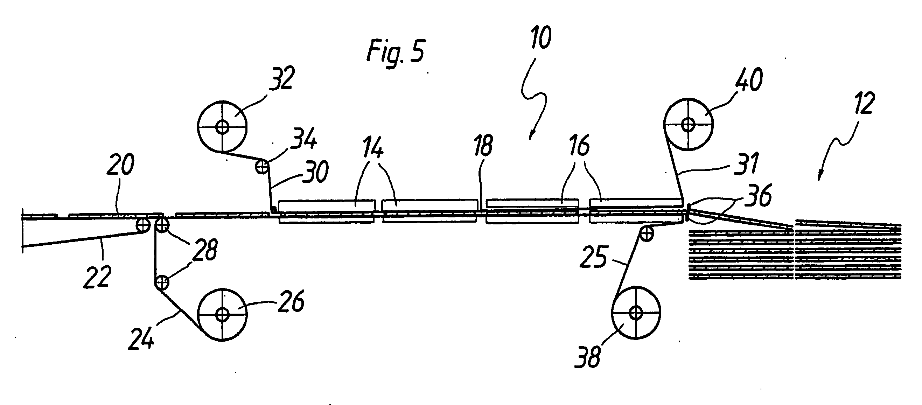

An einem in Förderrichtung hinteren Ende der letzten Presseinrichtung 16 ist eine Trenneinrichtung 36 mit zwei Messern angebracht, die sich mit den bewegbaren Presseinrichtungen 16 mitbewegt. Die Trenneinrichtung 36 trennt das Laminiergut 18 nach jedem Rückbewegungsschritt in einem Zwischenraum zwischen den Innenlagen 20 in Platten, die die Multilayer 12 enthalten und die zwei Stapel am Ende Vorrichtung 10 bilden. Jede Platte kann einen oder mehrere, später voneinander zu trennende Multilayer 12 aufweisen. Das Schneiden in die beiden die Multilayer 12 aufweisenden Platten erfolgt jeweils in Figur 4 und in Figur 5.

Nach dem, Laminieren werden die Kunststofffolien 15, 31 der Außenlagebänder 24, 30 vom Laminiergut getrennt. Dies erfolgt durch Aufwickeln auf Aufwickelrollen 38, 40, die nicht dargestellte Drehantriebe aufweisen. Die Aufwickelrollen 38, 40 sind am Ende der Vorrichtung 10 ober- und unterhalb des Laminierguts 18 angeordnet. Das Abziehen der Kunststofffolien 25, 31 vom Laminiergut 18 ist möglich, weil die Kunststofffolien 25, 31 der Außenlagebänder 24, 30 einen höheren Schmelzpunkt als das Harz der Innenlagen 20 aufweisen und das Laminiergut 18 in den Presseinrichtungen 14, 16 nicht bis auf eine Schmelztemperatur der Kunststofffolien 25, 31 der Außenlagebänder 24, 30 erwärmt werden. Deswegen haften die Kunststofffolien 25, 31 der Außenlagebänder 24, 30 nach dem Laminieren lediglich am Laminiergut 18 und verbinden sich nicht stoffschlüssig mit dem Laminiergut 18. Die Kunststofffolien 25, 31 lassen sich daher nach dem Laminieren durch Abziehen vom Laminiergut 18 entfernen.

Beim Bewegen der beiden letzten Presseinrichtungen 16 in Förderrichtung werden die Kunststofffolien 25, 31 der Außenlagebänder 24, 30 um hintere Ränder der letzten Presseinrichtung 16 umgeschlagen und durch die Bewegung der Presseinrichtungen 16 von den Aufwickelrollen 38, 40 abgewickelt, wie in Figur 2 zu sehen ist. Die Aufwickelrollen 38, 40 sind dabei frei oder gebremst drehbar. Beim Zurückbewegen der beiden letzten Presseinrichtungen 16 entgegen der Förderrichtung werden die Aufwickelrollen 38, 40 drehend angetrieben und wickeln die Kunststofffolien 25, 31 auf. Die Kunststofffolien 25, 31 werden zwischen der letzten Presseinrichtung 16 und der Trenneinrichtung 36 umgeschlagen, so dass sie beim Trennen des Laminierguts 18 in die Multilayer 12 nicht durchtrennt werden. Die Kunststofffolien 25, 31 der Außenlagebänder 24, 30 werden also von den Vorratsrollen 26, 32 abgewickelt und nach dem Laminieren auf die Aufwickelrollen 38, 40 aufgewickelt. Die Aufwickelrollen 38, 40 bilden mit ihren nicht dargestellten Drehantrieben Wickeleinrichtungen einer Abführeinrichtung für die Kunststofffolien 25, 31 der Außenlagebänder 24, 30. Die Kunststofffolien 25, 31 dienen einem Schutz des Laminierguts 18 vor Verschmutzung. Sie werden fabrikneu und damit schmutzfrei von den Vorratsrollen 26, 32 abgewickelt.

Die Kunststofffolien 25, 31 der die Außenlagen 24, 30 bildenden Verbundfolien bilden äußerste Lagen 25, 31 der Außenlagebänder 24, 30. Anstelle der Verwendung von Verbundfolien als Außenlagebänder 24, 30 können die Metallfolien und die Kunststofffolien auch von jeweils getrennten Vorratsrollen abgewickelt und den Presseinrichtungen 14, 16 zugeführt werden (nicht dargestellt). Das Entfernen der Kunststofffolien vom Laminiergut 18 nach dem Laminieren durch Aufwickeln auf die Aufwickelrollen 38, 40 bleibt unverändert. In diesem Fall können die Kunststofffolien als eine von mehreren Außenlagen der Außenlagebänder aufgefasst werden.

## Patentansprüche

1. Vorrichtung (10) zum schrittweisen Laminieren von Multilayern (12),
- mit einer Anzahl Presseinrichtungen (14, 16), die aufeinanderfolgend entlang einer Förderstrecke angeordnet sind, die Heiz- und/oder Kühleinrichtungen aufweisen und die einzeln oder in Gruppen temperierbar sind,
- mit einer Einrichtung (22) zum Zuführen einer Innenlage (20) des Multilayers (12, 18) in eine in einer Förderrichtung erste Presseinrichtung (14) und mit mindestens einer Einrichtung zum Zuführen mindestens eines Außenlagebandes (24,30) des Multilayers (12, 18) auf eine Außenseite der Innenlage und in die in Förderrichtung erste Presseinrichtung (14)
**dadurch gekennzeichnet, dass** mindestens eine in Förderrichtung letzte Presseinrichtung (16) in und entgegen der Förderrichtung bewegbar ist.

2. Vorrichtung nach Anspruch 1, **dadurch gekennzeichnet, dass** die Vorrichtung (10) eine Abführeinrichtung (38, 40) aufweist, die in Förderrichtung nach der letzten Presseinrichtung (16) angeordnet ist und die mindestens eine äußerste Lage (25, 31) der Außenlage (24, 30) von dem Multilayer (12, 18) entfernt.

3. Vorrichtung nach Anspruch 2, **dadurch gekennzeichnet, dass** die Abführeinrichtung (38, 40) eine Wickeleinrichtung (38, 40) mit einem Drehantrieb aufweist, die die mindestens eine Lage (25, 31) der Außenlage (24, 30) oder die mindestens eine von mehreren Außenlagen nach der letzten Presseinrichtung (16) aufwickelt.

4. Vorrichtung nach einem der Ansprüche 1 bis 3, **dadurch gekennzeichnet, dass** die Vorrichtung eine Trenneinrichtung (36) aufweist, die in Förderrichtung nach der letzten Presseinrichtung (16) und nach der Abführeinrichtung (38, 40) angeordnet ist und die die Multilayer (12) voneinander trennt.

## Claims

1. Device (10) for step-wise lamination of multilayers (12),
- having a number of press devices (14, 16) which are disposed in succession along a conveying stretch, which have heating and/or cooling devices and which can be temperature-controlled individually or in groups,
- having a device (22) for supplying an inner layer (20) of the multilayer (12, 18) into a press device (14) which is first in a conveying direction and having at least one device for supplying at least one outer layer strip (24, 30) of the multilayer (12, 18) onto an outer side of the inner layer and into the press device (14) which is first in the conveying direction,
**characterised in that at least** one press device (16) which is last in the conveying direction is movable in and counter to the conveying direction.

2. Device according to claim 1, **characterised in that** the device (10) has a discharge device (38, 40) which is disposed in the conveying direction after the last press device (16) and removes the at least one outermost layer (25, 31) of the outer layer (24, 30) from the multilayer (12, 18).

3. Device according to claim 2, **characterised in that** the discharge device (38, 40) has a winding device (38, 40) with a rotary drive which winds up the at least one layer (25, 31) of the outer layer (24, 30) or the at least one of a plurality of outer layers after the last press device (16).

4. Device according to one of the claims 1 to 3, **characterised in that** the device has a separating device (36) which is disposed in the conveying direction after the last press device (16) and after the discharge device (38, 40) and which separates the multilayers (12) from each other.

## Revendications

1. Dispositif (10) pour laminer des multicouches (12) par étapes,
- comprenant plusieurs dispositifs de compression (14, 16) disposés les uns à la suite des autres le long d'un tronçon de transport, qui présentent des dispositifs de chauffage et/ou de refroidissement et qui peuvent être tempérés individuellement ou par groupes,
- comprenant un dispositif (22) pour amener une couche intérieure (20) du multicouche (12, 18) dans un premier dispositif de compression (14) par rapport au sens de transport et au moins un dispositif pour amener au moins une bande formant la couche extérieure (24, 30) du multicouche (12, 18) sur une face extérieure de la couche intérieure et dans le premier dispositif de compression (14) par rapport au sens d'avance,
**caractérisé en ce qu'**au moins un dernier dispositif de compression (16) par rapport au sens de transport peut être déplacé dans le sens de transport et dans le sens opposé à ce dernier.

2. Dispositif selon la revendication 1, **caractérisé en ce que** le dispositif (10) présente un dispositif d'évacuation (38, 40) qui est situé en aval du dernier dispositif de compression (16) par rapport au sens de transport et qui retire au moins une pellicule extérieure (25, 31) de la couche extérieure (24, 30) du multicouche (12, 18).

3. Dispositif selon la revendication 2, **caractérisé en ce que** le dispositif d'évacuation (38, 40) présente un dispositif enrouleur (38, 40) équipé d'un entraînement en rotation, qui enroule au moins l'unique pellicule (25, 31) de la couche extérieure (24, 30) ou au moins l'unique pellicule de plusieurs couches extérieures à la sortie du dernier dispositif de compression (16).

4. Dispositif selon l'une des revendications 1 à 3, **caractérisé en ce que** le dispositif présente un dispositif de coupe (36) qui est disposé, par rapport au sens de transport, en aval du dernier dispositif de compression (16) et en aval du dispositif d'évacuation (38, 40) et qui sépare les multicouches (12) les uns des autres.
